# EUROPEAN PATENT SPECIFICATION

(11) **EP 2 729 243 B1**
(45) Date of publication and mention of the grant of the patent: **24.08.2016**
(21) Application number: 12735635.0
(22) Date of filing: 15.06.2012
(51) Int. Cl.: B01J 13/02, C01B 21/068, C01B 31/02, C01B 31/36, C01B 33/027, C01B 33/029, C22C 27/04, B82Y 30/00, B82Y 40/00

(54) **METHOD OF PRODUCING NANOPARTICLES BY GENERATING AN ELECTRICAL SPARK**
VERFAHREN ZUR HERSTELLUNG VON NANOPARTIKELN DURCH ERZEUGUNG EINES ELEKTRISCHEN FUNKENS
PROCÉDÉ DE PRODUCTION DE NAOPARTICULES par création d'une décharge électrique

(30) Priority: 08.07.2011 ZA 201105035
(43) Date of publication of application: 14.05.2014
(73) Proprietor: PST Sensors (Pty) Limited, 7700 Cape Town (ZA)
(72) Inventor: BRITTON, David Thomas, 8001 Cape Town (ZA); SCRIBA, Manfred Rudolf, 0184 Pretoria (ZA)
(74) Representative: Bennett, Nicholas
(86) International application number: PCT/IB2012/053023
(87) International publication number: WO 2013/008112

(56) References cited:
- US-A1- 2005 258 419
- KEIL D G ET AL: "Combustion synthesis of nanosized SiCxNy powder's", MATERIALS RESEARCH SOCIETY SYMPOSIUM PROCEEDINGS, vol. 410, 1 January 1996 (1996-01-01), pages 161-166, XP009172433, MATERIALS RESEARCH SOCIETY, PITTSBURG, PA; US ISSN: 0272-9172
- VIVET F ET AL: "Synthesis and characterization of SiC:H ultrafine powder generated in an argon-silane-methane low-pressure radio-frequency discharge", JOURNAL OF APPLIED PHYSICS, vol. 83, no. 12, 15 June 1998 (1998-06-15) , pages 7474-7481, XP012044385, AMERICAN INSTITUTE OF PHYSICS. NEW YORK, US ISSN: 0021-8979, DOI: 10.1063/1.367510
- MANGOLINI L ET AL: "High-Yield Plasma Synthesis of Luminescent Silicon Nanocrystals", NANO LETTERS, vol. 5, no. 4, 1 April 2005 (2005-04-01), pages 655-659, XP009172435, AMERICAN CHEMICAL SOCIETY, US ISSN: 1530-6984, DOI: 10.1021/NL050066Y [retrieved on 2005-06-05]
- YOSHIHIKO KANEMITSU: "Chapter 5 Silicon and Germanium Nanoparticles", SEMICONDUCTORS AND SEMIMETALS, vol. 49, 1 January 1997 (1997-01-01), pages 157-204, XP009172434, ACADEMIC PRESS, SAN DIEGO, CA, US ISSN: 0080-8784, DOI: 10.1016/S0080-8784(08)62503-X
- KLEIN S ET AL: "REDUCED-PRESSURE CHEMICAL VAPOR SYNTHESIS OF NANOCRYSTALLINE SILICON CARBIDE POWDERS", CHEMICAL VAPOR DEPOSITION, vol. 4, no. 4, 1 June 1998 (1998-06-01), pages 143-149, XP000774449, WILEY-VCH VERLAG, WEINHEIM, DE ISSN: 0948-1907, DOI: 10.1002/(SICI)1521-3862(199807)04:04<143:: AID-CVDE143>3.0.CO;2-Z
- Anonymous: "Capacitor", Wikipedia, the free encyclopedia , 4 September 2013 (2013-09-04), page 1, 12, XP002712771, Retrieved from the Internet: URL:http://en.wikipedia.org/wiki/Capacitor [retrieved on 2013-09-11]

## Description

### BACKGROUND OF THE INVENTION

This invention relates to a process for the production of nanoparticles by chemical vapour synthesis (CVS) involving the pyrolysis of at least one molecular precursor species.

The CVS method of particle production is based on the pyrolysis of at least one precursor gas. For the purposes of this specification pyrolysis refers to the thermally assisted cracking of molecules, although other kinematic collision processes may occur, into radicals such as atoms and ions. Chemical vapour synthesis refers to the complete process of assembling larger units such as molecules, atomic clusters, nanoparticles and even micron scale particles from the reactive species produced during the pyrolysis, or through their interaction with the molecules of the unreacted gas. This interaction may be a direct chemical reaction or the promotion of a chemical reaction through catalytic activity.

In these processes the inclusion of low concentrations of additional gases may result in the inclusion of dopant atoms in the nanoparticles or the formation of alloys. Processes that are known to practitioners skilled in the art of nanoparticle production from the vapour phase include laser pyrolysis, hot wall reactor synthesis and plasma pyrolysis. Nanoparticles produced by such methods are of industrial significance for their applications as phosphors, in printed electronics, in tribology, magnetic and electrorheological fluids, and in nanocomposite materials, as well as finding a wide use in advanced scientific research.

The document Keil D. G. et al. "Combustion synthesis of nanosized SiCxNy powders", Materials research society symposium proceedings; materials research society, Pittsburg, PA; US, vol. 410, 1 January 1996, (pages 161-166), discloses only the use of a spark to ignite a self-propagating flame (see abstract) for a conventional exothermic chemical reaction, in which the spark and its associated localised plasma play no further role. The combustion reaction occurs after the spark has died away and throughout the chamber.

The documents Vivet F. et al. "Synthesis and characterization of SiC:H ultrafine powder generated in an argon-silane-methane low-pressure radio-frequency discharge", Journal of applied physics, American institute of physics. New York, US, vol. 83, no. 12, 15 June 1998, (pages 7474-7481), and Mangolini L. et al. "High-Yield Plasma Synthesis of Luminescent Silicon Nanocrystals", Nano letters, American Chemical Society, US, vol. 5, no 4, 1 April 2005, (pages 655-659), describe conventional RF excited plasma pyrolysis, in which sparks are explicitly avoided. In these methods, the RF field excites (i.e. generates a plasma) in the whole atmosphere. This also occurs continuously over an extended time. Such an excitation process is a glow discharge and not a spark.

The document Yoshihiko Kanemitsu "Chapter 5 Silicon and Germanium Nanoparticles", Semiconductors and semimetals, academic press, San Diego, CA, US, vol. 49, 1 January 1997, (pages 157-204), describes laser pyrolysis of silane to produce heavily oxidised nanoparticles. No electrical spark is created, but rather an instantaneous light emission - more similar to the light emission emitted by a flint or a firework sparkler - which only indicates that the reaction has occurred releasing energy.

The document US 2005/0258419 A1 describes a "plasma microreactor", which uses a continuous dc potential between two electrodes. This is essentially a continuous glow discharge and the electrodes are constructed as tubes to avoid sparking between them.

### SUMMARY OF THE INVENTION

In general, there is a method of producing nanoparticles through the synthesis of one or more precursor fluids, wherein at least one such precursor undergoes pyrolysis, or cracking, initiated by an electrical spark, to produce one or more radical species. The radical species acts as a reactant or catalytic agent in the synthesis of the material composing the nanoparticle which forms by nucleation in the fluid medium. In a preferred embodiment the fluids compose a low pressure gaseous environment, but such a spark may also be caused to occur in an insulating liquid. In the latter case, the liquid itself may form a precursor material or it may comprise a solution containing the precursor materials. Alternatively, in a gaseous environment, liquid or solid precursor materials may be introduced into the region of the spark as an aerosol of particles or droplets in a stream of a carrier gas. This carrier gas may itself comprise a precursor material or may be inert, and not participate in any chemical processes. Similarly, an inert gas may be added to the precursor gases as a dilutant.

According to the invention there is provided the method of claim 1.

The electrical discharge forming the spark preferably has a frequency between 1 Hz and 100 Hz.

The spark has a total energy between 0.01 J and 10 J and preferably between 0.1 and 1 J.

The precursor materials may all be in gaseous form.

Alternatively, at least one of the precursor materials may be in liquid form, the said liquid form, the said liquid being either a pure non-conducting liquid or a non-conducting solution of other materials in an appropriate solvent.

Further alternatively, at least one of the precursor materials may ordinarily be a solid or liquid and be introduced into the spark as an aerosol composed of particles or droplets in a carrier gas.

In a preferred embodiment of the method, rapid condensation of the nanoparticles away from the region of the spark results in the formation of spherical nanoparticles.

The spherical nanoparticles may be single crystalline.

The nanoparticles may form compact spherical or ellipsoidal clusters.

The nanoparticles may be agglomerated to form chains, a branched cluster, or a network.

The nanoparticles may nucleate around a pre-existing nanoparticle to produce a binary nanoparticle with a core-shell structure.

In particular, the nanoparticles may be nucleated around pre-existing nanoparticles injected into cooler regions of the medium surrounding the spark to form binary nanoparticles with a core-shell structure.

Different precursor materials may be introduced at different distances from the spark allowing the nucleation of heterogeneous particles with either a composition gradient or a core-shell structure, which may comprise multiple shells.

The nanoparticles may comprise silicon.

The nanoparticles may comprise a compound of silicon, including silica, silicon carbide, or silicon nitride.

The nanoparticles may comprise an alloy of silicon including silicon doped with boron, phosphorous or arsenic, and also silicon-carbon and silicon-germanium alloys.

The nanoparticles may comprise a polymer.

The nanoparticles produced by the method of the invention comprise inorganic semiconductor materials, and have non-insulating surfaces for use in electronic and electrical applications in general, and specifically in those applications where semiconducting properties are required.

### BRIEF DESCRIPTION OF THE DRAWINGS

- **Figure 1**: is a schematic diagram showing the production of nanoparticles formed by using an electric spark generated between two electrodes in the reaction chamber of Figure 1;
- **Figure 2**: is a transmission electron microscope (TEM) image obtained from silicon nanoparticles produced according to the method of the invention;
- **Figure 3**: is a histogram of the size distribution of silicon nanoparticles produced according to the method of the invention.
- **Figure 4**: is a high magnification TEM image of a silicon nanoparticle produced according to the method of the invention; and
- **Figure 5**: is a graph of the resistivity of compressed silicon nanopowder produced by the method of the invention; and

### DESCRIPTION OF PREFERRED EMBODIMENTS

In this invention, an electric discharge or spark is used to perform the pyrolysis of one or more precursor gases, specifically for the production of stable nanoparticles by chemical vapour synthesis, involving the pyrolysis of at least one molecular precursor species and the nucleation of the nanoparticles in the surrounding gaseous environment. It particularly concerns the synthesis of nanoparticles of inorganic semiconductor materials, with non-insulating surfaces for use in electronic and electrical applications in general, and specifically in those applications where semiconducting properties are required.

Early well-known experiments investigated the use of a high energy spark to promote the synthesis of complex organic molecules from simple precursor gases. Specifically, compounds such as amino acids were produced from the mixture of gases, including methane, oxygen and ammonia, expected in the atmosphere of the young earth. The spark pyrolysis method relies on the dissociation or cracking of the precursor gases by the electrical excitation of the electrons and ions in the spark plasma. The process has similarities to the method of pulsed laser pyrolysis, which has short heating and rapid cooling cycles, but differs significantly in both the method of excitation and the spatial extent of the plasma and the associated temperature profile in the surrounding gas. Similarly the method described here has superficial similarities to plasma enhanced chemical vapour synthesis, as described in WO 2010/027959, US 2006/0051505, and US 2006/269690, which uses a radio frequency coupling of the electrical excitation, but which effectively excites the whole gaseous atmosphere.

A similar method to that described here, which does not involve the crucial pyrolysis step, is the well-known production of nanoparticles by a continuous arc between two separated electrodes, as described in WO 2003/022739 or JP 2010/095422, of which at least one is made of the material which composes the nanoparticles. Material from one or both electrodes is evaporated into the arc plasma, leading to the formation of nanoparticles through nucleation in the surrounding medium. Known modifications to this method include evaporating the electrode material into a reactive environment, such as air or oxygen, to produce oxide nanoparticles.

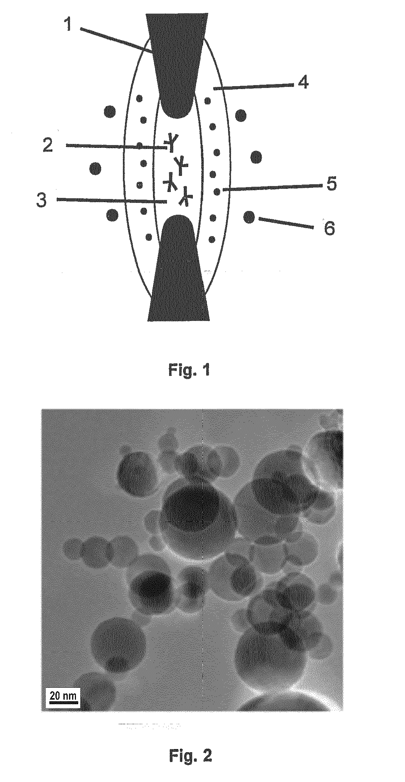

Figure 1 shows, schematically, the processes occurring during the chemical vapour synthesis. When an arc discharge is generated between two electrodes (1), radical species (2) are produced by pyrolysis of one or more precursors in the relatively hot plasma core of the spark (3). One or more of the resulting radical species undergo interactions in a cooler reaction region (4) surrounding the plasma core of the spark to form the species (5) which comprise the desired nanoparticle. The interactions between the radical species, or between the radical and unreacted species, may simply form a route to chemical synthesis, or at least one such radical may act a as a catalytic agent which promotes a reaction between any of the other species present. More particularly such a catalytic reaction should involve one or more uncracked precursor species.

Local supersaturation of the final product results in nucleation and growth of nanoparticles (6) in the surrounding medium. The size, morphology and internal structure of the particles is thus primarily controlled by five factors: the pressure and temperature of the surrounding medium, and the length, energy and duration of the spark. Nanoparticles can be produced in the size range 1 nm to 1000 nm, but are preferably in the range 5 nm to 200 nm, and more preferably in the range 20nm to 70 nm.

In this invention, a plasma with a small spatial extent is formed in the spark. Thus the cracking processes are similar to those occurring in plasma enhanced chemical vapour synthesis in that other kinematic collision processes may play a role in the cracking of the precursor molecules to form the radical species. Another superficial similarity with plasma enhanced chemical vapour synthesis is the electrical excitation of the plasma, which differs in the present invention in that it is directly coupled and only excites a limited region of the medium directly between the two electrodes and not the whole gaseous atmosphere as in methods employing radiofrequency coupling used in the prior art.

In the present invention therefore, the fluid medium contains cooler regions than in plasma enhanced chemical vapour synthesis, so that particles may form and cool at a faster rate thus limiting the growth and the rearrangement of the atoms or, molecules constituting the particle. The method therefore is better suited to the production of small spherical particles, which may be amorphous, polycrystalline or single crystalline. Through control of the physical parameters of the surrounding material, for example for gas phase synthesis the flow rate, pressure, chamber temperature and the presence of quenching or dilution gases, the crystallinity can be controlled and spherical single crystal particles in the desired size range can be obtained.

Unlike in the plasma enhanced chemical vapour phase synthesis, in the method disclosed here the spark and associated plasma are short-lived, and so the temporal profile of the plasma bears some similarity to that found in pulsed laser pyrolysis, which has short heating and longer cooling cycles. However, the present method differs significantly not only in the method of excitation, but also the spatial extent of the plasma, and hence the temperature profile in the surrounding medium. More particularly, in the present invention the spark does not significantly heat the surrounding medium.

Variation of the temperature and pressure in the surrounding medium can be used to change the nucleation and condensation rates of the particles allowing the formation of larger structures. In particular, particles may be fused in situ to form compact spherical or ellipsoidal clusters, chains, branched clusters or complex dendritic networks. At elevated temperatures, if the nanoparticles are allowed to impinge on a substrate the method may be suitable for the deposition of compact layers and coatings.

The invention can be used to produce nanoparticles of most materials whose precursors may be introduced to the spark in the gas or liquid phase or as an aerosol. In the aerosol the carrier gas may be either inert or be composed of one of the precursor materials. The invention thus includes the fabrication of nanoparticles of all materials known to be deposited as thin films in chemical vapour deposition (CVD) processes, such as semiconductors, metals and ceramics. In an analogous manner to most known chemical vapour deposition processes, doping and alloying can be accomplished by mixing the precursor and dopants prior to feeding the mixture into the chamber, or by injecting them separately into the region of the spark. Similarly, inclusion of other phases, for example for the production of a binary particle with a core shell structure, may be achieved by injection of an aerosol into the nucleation region surrounding the spark.

The methods disclosed are particularly suited to the production of nanoparticles comprised of: silicon; its compounds such as silica, silicon nitride and silicon carbide; and its alloys including, inter alia, boron doped and phosphorous doped silicon, as well as silicon-carbon and silicon-germanium alloys.

Polymer and other organic nanoparticles, as well as carbon phases such as nanotubes and buckminster-fullerene molecules, may be produced by using the spark to pyrolise the precursor of a catalytic radical in a process similar to that occurring at the hot filament in initiated chemical vapour deposition as described by Gleeson et al in.WO2007145657. Of particular relevance are fluorocarbons, as disclosed in WO9742356, and polyglycidylmethacrylate (PGMA), which may be nucleated around a core of a pre-existing metallic or ceramic nanoparticle as disclosed above.

In a preferred embodiment of the invention a spark is produced in a gaseous environment inside a reaction chamber by the application of a high electric potential between two electrodes. The reaction chamber may vary in size and may be constructed from stainless steel or glass or any other suitable material and is sealed to atmosphere by O-rings or the like, preventing the ingress of air into the chamber. The reaction chamber is filled with precursor gases which are introduced into the reaction chamber, and whose flow rate and pressure may be regulated. According to the invention the morphology, structure, crystallinity and size of the nanoparticles produced by the spark pyrolysis can be affected by the variation of the spark gap distance, energy of the spark, the pressure inside the reaction chamber, the flow rate and composition of the precursor gases.

The electrodes may constitute any conductive material, but a refractory metal with a high melting point and resistance to corrosion is preferred. From experience tungsten wire has proved to be an excellent electrode material. A spark will be produced only if the conditions for the ionisation of the gas in the chamber are satisfied. The conditions are determined by the pressure, voltage and spark distance. For a fixed spark gap the potential over the spark gap will thus have to be high enough to initiate the spark at a particular pressure. The spark location inside the chamber as well as the chamber size may also be varied to affect the particle size and agglomeration of the nanoparticles. The nucleation rate of nanoparticles may further be regulated by controlling the temperature of the chamber by either cooling or heating.

The precursor gas or gases may be introduced into the reaction chamber through a single inlet or through multiple inlets at the same or different locations on the chamber, allowing spatially varying distribution of precursors and reactive species. As an example, one or more gases may be distributed radially inside the chamber, facilitating the growth of nanoparticles with a gradient in their composition or a core-shell structure, with the possibility of multiple shells, as different species nucleate at different distances from the spark.

### Example: production of doped silicon nanoparticles

To illustrate the method of the invention more fully, the production of p-type silicon nanoparticles is used as one example. The precursor gas was pure monosilane (SiH₄) diluted with 0.1% by volume of diborane (B₂H₆), which was delivered to the reaction chamber at a flow rate of 50 sccm and maintained at a pressure of 80 mbar. The level of doping in the resulting nanoparticles can be controlled by varying the concentration of diborane from approximately 1 part per million to in excess of 10% by volume. Any other known dopants can be added to the nanoparticles by the inclusion of their respective known precursors. As a particular example, n-type doping with phosphorous is achieved by the addition of phosphine or diphosphine, and with arsenic by the addition of arsine.

Other known silicon precursors such as disilane, and halogenated silanes such as the chlorosilanes or fluorosilanes, may be used. An inert dilutant gas such as argon or helium, may be used. Dilution of the precursor gas with hydrogen, as is well known in the chemical vapour deposition of silicon films, will also result in the production of nanoparticles, but is not recommended for the attainment of a stable surface. Particles comprising oxides, nitrides and oxynitrides, or with a surface layer comprised of such materials, can be produced by using one of either or both of oxygen and nitrogen as the dilutant gases, respectively.

Similarly, particles comprising alloys or compounds of silicon with other elements can be synthesised by including the precursors known to practitioners of chemical vapour deposition for these materials. This list is extensive, and should not be restricted to the following examples. Carbon, to synthesise nanoparticles of silicon carbide or silicon-carbon alloys, may be included, for example, by the addition of methane, a short chain alkane such as ethane, propane or butane, or alkene such as ethane or propene, as a secondary precursor gas, or an aromatic compound or other higher hydrocarbon in nebulised form. Similarly nanoparticles comprising silicon-germanium alloys, or elemental germanium, can be produced by the addition, or replacement, of the silane with a corresponding germane. The high voltage power supply used to generate the spark was left in free running mode, with a capacitor repeatedly charging and discharging across the spark gap. In this arrangement, the average frequency of the spark discharge and its energy depends on the breakdown voltage, which depends on the size of the spark gap and the pressure inside the reaction chamber. In the present example the spark frequency is 9.5 Hz and the spark energy in the region of 0.6 J.

In an alternative process, a modulated high voltage pulse, for example but not limited to a square, triangular, sinusoidal or half-wave rectified waveform, with a defined frequency less than 1 kHz, and greater than 0.01 Hz, may be used. Most preferably the spark frequency should be between 1 Hz and 100 Hz, with a total energy per spark between most preferably 0.1 to 1 J.

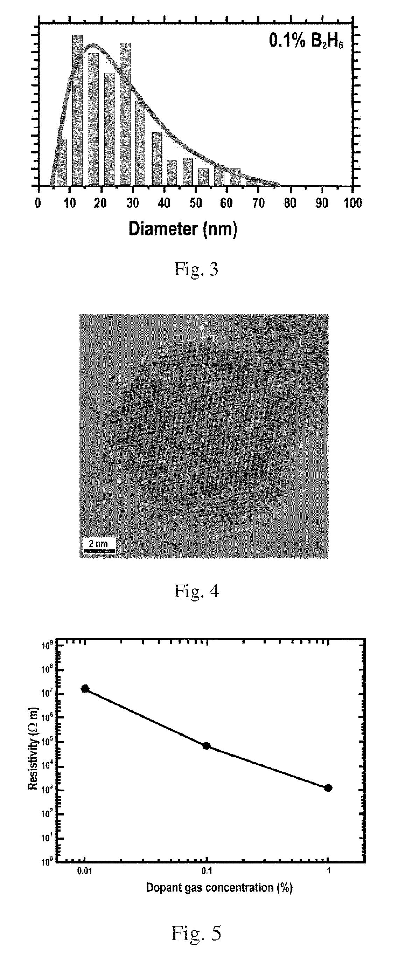

The silicon nanoparticles produced in accordance with the above described example of the invention are shown in the TEM image of Figure 2. The silicon nanoparticles are spherical with a mean particle diameter between 20 and 40 nm as shown in the particle size distribution histogram of Figure 3. The histograms represent intrinsic silicon nanoparticles produced at 40 mbar.

The silicon nanoparticles produced in accordance with the method of the invention, at 80 mbar with 0.1% diborane, are monocrystalline. This is revealed in the TEM images in Figure 4, by the lattice structure visible over the full particle. It shows how the crystal structure extends fully, up to the outer atomic layer of the particle.

Both the size and the crystallinity of the nanoparticles, can be modified by control of the nucleation rate and temperature in the nucleation zone by varying the spark energy, pressure and flow rate of the gases in the reaction chamber. Rapid nucleation results in the formation of spherical particles, and at high pressure will lead to a polycrystalline or amorphous internal structure. At higher flow rates the particles will be smaller and less agglomerated. Control of the gas flow, and the reaction parameters, can therefore also allow synthesis of large structures comprising nanoparticles, such as compact spherical or ellipsoidal clusters, branched dendritic clusters, and large networks of particles.

Doping of the silicon nanoparticles with boron was confirmed by a reduction in resistivity with an increase in the concentration of the diborane precursor gas. The resistivity of the particles produced according to the method of the invention was measured by compressing a measured quantity of reference silicon nanopowder and the same quantity of nanopowder produced by the method of the invention, to the same density, between two conducting rods. The resistivity of the silicon nanoparticles produced in accordance with the invention, at 80 mbar with 0.01%, 0.1% and 1% diborane concentrations, is shown in Figure 5. The decrease in resistivity with the increasing diborane concentration indicates an increase in doping concentration in silicon nanoparticles produced according to the invention.

## Claims

1. A method of producing nanoparticles in the size range 1 nm to 1000 nm through the synthesis of one or more precursor fluids, the method including providing a fluid medium comprising at least one precursor fluid and generating an electrical spark within said fluid medium to cause pyrolysis of said at least one precursor fluid in a short-lived hot plasma core of the spark, the plasma having a small spatial extent, to produce at least one radical species, and to form nanoparticles by nucleation in the fluid medium in a cooler reaction zone surrounding the plasma core of the spark, wherein said at least one radical species acts as a reactant or catalytic agent in the synthesis of material composing said nanoparticles, wherein the spark is created by an electrical discharge having a frequency between 0.01 Hz and 1 kHz, and has a total energy between 0.01 J and 10 J.

2. A method according to claims 1 wherein the precursor fluid comprises at least one precursor material in a gaseous form.

3. A method according to either of claims 1 or 2 wherein the precursor fluid comprises at least one precursor material in a liquid form, being either a pure non-conducting liquid or a non-conducting solution of other materials in an appropriate solvent.

4. A method according to any one of claims 1 to 3 wherein the precursor fluid comprises at least one precursor material which is ordinarily a solid or liquid and is introduced into the spark as an aerosol composed of particles or droplets in a carrier gas.

5. A method according to any one of claims 1 to 4 wherein rapid condensation of the nanoparticles away from the region of the spark results in the formation of spherical nanoparticles.

6. A method according to claim 5 wherein the spherical nanoparticles are single crystalline.

7. A method according to claim 5 or claim 6 wherein the nanoparticles form compact spherical or ellipsoidal clusters.

8. A method according to any one of claims 1 to 7 wherein nanoparticles are agglomerated to form chains, a branched cluster, or a network.

9. A method according to any one of claims 1 to 8 wherein nanoparticles nucleate around pre-existing nanoparticles to produce binary nanoparticles with a core-shell structure.

10. A method according to any one of claims 1 to 9 wherein different precursor materials are introduced at different distances from the spark allowing the nucleation of heterogeneous particles with either a composition gradient or a core-shell structure.

11. A method according to any one of claims 1 to 10 wherein the nanoparticles comprise silicon; a compound of silicon including silica, silicon carbide, or silicon nitride; or an alloy of silicon including silicon doped with boron, phosphorous or arsenic, a silicon-carbon alloy or a silicon-germanium alloy.

12. A method according to any one of claims 1 to 10 wherein the nanoparticles comprise a polymer.

13. A method according to any one of claims 1 to 12 wherein the nanoparticles comprise inorganic semiconductor materials and have non-insulating surfaces for use in electronic and electrical applications in general, and specifically in those applications where semiconducting properties are required.

## Patentansprüche

1. Verfahren zum Erzeugen von Nanoteilchen im Größenbereich von 1 nm bis 1000 nm durch die Synthese eines Vorläuferfluids oder mehrerer Vorläuferfluida, wobei das Verfahren ein Bereitstellen eines Fluidmediums, das zumindest ein Vorläuferfluid umfasst, und das Erzeugen eines Elektrofunkens in dem Fluidmedium, um eine Pyrolyse des mindestens einen Vorläuferfluids in einem kurzlebigen heißen Plasmakern des Funkens zu bewirken, enthält, wobei das Plasma ein geringes räumliches Ausmaß hat, um zumindest eine Radikalspezies zu erzeugen und Nanoteilchen durch Keimbildung im Fluidmedium in einer Kühlerreaktionszone, die den Plasmakern des Funkens umgibt, zu bilden, wobei die zumindest eine Radikalspezies als Reaktionsmittel oder katalytisches Mittel in der Synthese von Material dient, das die Nanoteilchen umfasst, wobei der Funke durch eine elektrische Entladung mit einer Frequenz zwischen 0,01 Hz und 1 kHz erzeugt wird und eine Gesamtenergie zwischen 0,01 J und 10 J hat.

2. Verfahren nach Anspruch 1, wobei das Vorläuferfluid zumindest ein Vorläufermaterial in einem gasförmigen Zustand umfasst.

3. Verfahren nach Anspruch 1 oder 2, wobei das Vorläuferfluid zumindest ein Vorläufermaterial in einem flüssigen Zustand umfasst, das entweder eine reine, nicht leitende Flüssigkeit oder eine nicht leitende Lösung aus anderen Materialien in einem geeigneten Lösungsmittel ist.

4. Verfahren nach einem der Ansprüche 1 bis 3, wobei das Vorläuferfluid zumindest ein Vorläufermaterial umfasst, das normalerweise ein Feststoff oder eine Flüssigkeit ist und in den Funken als ein Aerosol eingeleitet wird, das aus Teilchen oder Tröpfchen in einem Trägergas besteht.

5. Verfahren nach einem der Ansprüche 1 bis 4, wobei eine rasche Kondensation der Nanoteilchen, weg von der Region des Funkens, zur Bildung sphärischer Nanoteilchen führt.

6. Verfahren nach Anspruch 5, wobei die sphärischen Nanoteilchen einzelkristallin sind.

7. Verfahren nach Anspruch 5 oder Anspruch 6, wobei die Nanoteilchen kompakte sphärische oder ellipsenförmige Anhäufungen (Cluster) bilden.

8. Verfahren nach einem der Ansprüche 1 bis 7, wobei Nanoteilchen zur Bildung von Ketten, einer verzweigten Anhäufung oder eines Netzwerks agglomeriert sind.

9. Verfahren nach einem der Ansprüche 1 bis 8, wobei Nanoteilchen um bereits bestehende Nanoteilchen keimen, um binäre Nanoteilchen mit einer Kern-Schale-Struktur zu erzeugen.

10. Verfahren nach einem der Ansprüche 1 bis 9, wobei verschiedene Vorläufermaterialien an unterschiedlichen Abständen zum Funken eingebracht werden, um eine Keimbildung heterogener Teilchen mit entweder einem Zusammensetzungsgradienten oder einer Kern-Schale-Struktur zu ermöglichen.

11. Verfahren nach einem der Ansprüche 1 bis 10, wobei die Nanoteilchen Silizium; eine Verbindung aus Silizium, die Siliziumdioxid, Siliziumcarbid oder Siliziumnitrid enthält; oder eine Legierung aus Silizium, die Silizium dotiert mit Bor, Phosphor oder Arsen, eine Silizium-Kohlenstoff-Legierung oder eine Silizium-Germanium-Legierung enthält, umfassen.

12. Verfahren nach einem der Ansprüche 1 bis 10, wobei die Nanoteilchen ein Polymer umfassen.

13. Verfahren nach einem der Ansprüche 1 bis 12, wobei die Nanoteilchen anorganische Halbleitermaterialien umfassen und nicht isolierende Oberflächen zur allgemeinen Verwendung in elektronischen und elektrischen Anwendungen aufweisen, und insbesondere in jenen Anwendungen, wo Halbleitereigenschaften erforderlich sind.

## Revendications

1. Procédé de production de nanoparticules dans la plage de tailles de 1 nm à 1000 nm par synthèse d'un ou de plusieurs fluides précurseurs, le procédé comprenant la fourniture d'un milieu de fluide comprenant au moins un fluide précurseur et la génération d'une étincelle électrique à l'intérieur dudit milieu de fluide pour provoquer la pyrolyse dudit au moins un fluide précurseur dans un noyau plasmatique chaud éphémère de l'étincelle, le plasma ayant une petite étendue spatiale, afin de produire au moins une espèce de radical, et de former des nanoparticules par nucléation dans le milieu de fluide dans une zone réactionnelle du refroidisseur entourant le noyau plasmatique de l'étincelle, dans lequel ladite au moins une espèce de radical agit comme réactif ou agent catalytique dans la synthèse du matériau composant lesdites nanoparticules, dans lequel l'étincelle est créée par une décharge électrique ayant une fréquence comprise entre 0,01 Hz et 1 kHz, et possède une énergie totale située entre 0,01 J et 10 J.

2. Procédé selon la revendication 1, dans lequel le fluide précurseur comprend au moins un matériau précurseur sous une forme gazeuse.

3. Procédé selon l'une quelconque des revendications 1 ou 2, dans lequel le fluide précurseur comprend au moins un matériau précurseur sous une forme liquide, qui est soit un liquide pur non-conducteur soit une solution non-conductrice d'autres matériaux dans un solvant approprié.

4. Procédé selon l'une quelconque des revendications 1 à 3, dans lequel le fluide précurseur comprend au moins un matériau précurseur qui est d'ordinaire un solide ou un liquide et qui est introduit dans l'étincelle sous la forme d'un aérosol constitué de particules ou de gouttelettes dans un gaz véhicule.

5. Procédé selon l'une quelconque des revendications 1 à 4, dans lequel la condensation rapide des nanoparticules hors de la région de l'étincelle aboutit à la formation de nanoparticules sphériques.

6. Procédé selon la revendication 5, dans lequel les nanoparticules sphériques sont monocristallines.

7. Procédé selon la revendication 5 ou la revendication 6, dans lequel les nanoparticules forment des clusters sphériques ou ellipsoïdaux compacts.

8. Procédé selon l'une quelconque des revendications 1 à 7, dans lequel les nanoparticules sont agglomérées pour former des chaînes, un cluster ramifié, ou un réseau.

9. Procédé selon l'une quelconque des revendications 1 à 8, dans lequel les nanoparticules forment un noyau autour des nanoparticules préexistantes pour produire des nanoparticules binaires ayant une structure coeur-écorce.

10. Procédé selon l'une quelconque des revendications 1 à 9, dans lequel différents matériaux précurseurs sont introduits à différentes distances de l'étincelle, ce qui permet la nucléation des particules hétérogènes avec soit un gradient de composition soit une structure coeur- écorce.

11. Procédé selon l'une quelconque des revendications 1 à 10, dans lequel les nanoparticules comprennent du silicium ; un composé de silicium comprenant de la silice, du carbure de silicium ou du nitrure de silicium ; ou un alliage de silicium comprenant du silicium dopé avec du bore, du phosphore ou de l'arsenic, un alliage de silicium - carbone ou un alliage de silicium-germanium.

12. Procédé selon l'une quelconque des revendications 1 à 10, dans lequel les nanoparticules comprennent un polymère.

13. Procédé selon l'une quelconque des revendications 1 à 12, dans lequel les nanoparticules comprennent des matériaux semi-conducteurs inorganiques et ont des surfaces non isolantes pour une utilisation dans des applications électroniques et électriques en général et spécifiquement dans les applications où des propriétés semiconductrices sont requises.
